# EUROPEAN PATENT APPLICATION

(11) **EP 4 756 874 A1**
(43) Date of publication of application: **10.06.2026**
(21) Application number: 24848433.9
(22) Date of filing: 19.07.2024
(51) Int. Cl.: H01L 23/467, G06F 13/20, F28F 13/16, H05K 7/20

(54) **ELECTROHYDRODYNAMIC HEAT SINK**

(30) Priority: 28.07.2023 ES 202330650
(71) Applicant: Cedrión Consultoría Técnica e Ingeniería SL, 28919 Leganés Madrid (ES)
(72) Inventor: PUAGO MARTÍNEZ, Héctor, 19004 Guadalajara (ES); VEGA MARTÍNEZ, Patricia, 28914 Madrid (ES)
(74) Representative: Cueto, Sénida
(86) International application number: PCT/ES2024/070467
(87) International publication number: WO 2025/027220

(57) **Abstract**

The invention relates to an electrohydrodynamic heat sink, formed by a conductive wire (5) disposed near to and parallel to a series of ground fins (4), in an elongate case (1) with an inlet hole (2) at a central point and two outlet holes (3) at the ends.(5 The case (1) has a larger flat face (11) that holds the ground fins (4), which are disposed between the outlet holes (3), and the internal space of the case (1) has a substantially triangular shape, with a greater height corresponding to the distance between the larger flat face (11) and the inlet hole (2) and a width corresponding to the distance between the outlet holes (3).

## Description

### TECHNICAL SECTOR

This application relates to an electrohydrodynamic heat sink for cooling components, especially electronic ones. It offers an improvement in the efficiency of heat dissipation, by optimising the flow of fluid through the collector electrode which, in addition to its function, acts as a heat sink.

### STATE OF THE ART

The present invention relates to the cooling of components in electronics. An electrohydrodynamic device (EHD) has a corona electrode and a collector electrode. The corona effect allows the ionization of a fluid surrounding the corona electrode and produces a movement of this fluid.

Electrohydrodynamic devices offer advantages due to their reduced size, low weight and power consumption, as well as reduced noise and vibrations. These characteristics mean that they are being used in cooling applications for small-scale components, replacing heat sinks or conventional fans.

Electrohydrodynamic devices currently used in cooling take advantage of the corona effect to direct a stream of air towards a finned heat dissipation element located downstream of the electrohydrodynamic device. Thus, the electrohydrodynamic device is used to produce air movement inside the component to be cooled and the fins of the heat sink are responsible for receiving the heat and dissipating it.

Electrohydrodynamic devices used in cooling are often known as electrohydrodynamic pumps since their function is to propel air, with the heat sink performing the dissipation function. See for example document US2012314334A1.

The state of the art is known as document CN113188106 where the device is arranged in a T-shaped casing and has central fins and three corona electrodes, one on each arm of the T. This system requires several corona electrodes, so its construction and efficiency are reduced. It is also noted that the fluid has several passageways that do not perform the function of capturing and removing heat from the fins.

KR101513402 is also known, where the collector electrodes are fins parallel to the corona electrode. These fins are of different heights, depending on their distance from the corona electrode. This system connects the fluid better with the fins, but the heat exchange is not optimized because the temperature difference is reduced in the final part of the air path. These applications also do not include sufficient information on the dimensions to obtain the best results. As will be demonstrated later, showing the entire length of the conductive wire, as this document does, obtains a worse dissipation result than the invention.

The applicant is not aware of any system that would solve all these problems as effectively as the invention.

### BRIEF EXPLANATION OF THE INVENTION

The invention consists of an electrohydrodynamic device according to the independent claims and whose variants solve the problems of the state of the art.

This device allows for optimal heat exchange, ensuring that the fluid comes into contact with the fins, maximizing heat exchange and reducing the volume required per calorie dissipated.

In this application, two values will be considered "similar" if the difference is less than 15%, preferably 10%, of the larger value.

The electrohydrodynamic heat sink is of the type formed by a conductor wire close to and parallel to a series of ground fins, all in an elongated casing with an inlet hole at a central point and two outlet holes at the ends. This generates a T-shaped flow, generally inverted according to the orientation on the element to be cooled. The casing has a flat larger face that carries the ground fins, arranged between the outlet holes. The inner hollow of the casing has a substantially triangular shape, with a greater height corresponding to the distance between the flat larger face and the inlet hole, and a width corresponding to the distance between the outlet holes. These outlet holes truncate the triangle, which will normally be isosceles and with a zenith angle greater than 90°, preferably greater than 120°.

Preferably the area of the inlet hole is similar to the total area of the outlet holes.

The fins can be all ground fins or include secondary fins, parallel to the ground fins and electrostatically independent of the conductive wire. That is, they are either not electrostatically charged or are too far away from the wire to generate an appreciable effect. These secondary fins only have a heat dissipation function, in contrast to the main or "ground" fins that also act as electrodes.

As will be indicated later, the housing may have a triangular shape directly or may include inserts defining the triangular shape. These inserts may have a wall facing the housing recess (between the inlet hole and each outlet hole) that is straight or curved, preferably convex.

The triangular shape can be optimized by modifying the height of the fins at the ends, by having the top of the casing inserted between the fins, reducing the usable passage section for the fluid, or in any other way. In these cases, the effective height of the fins in the centre is greater than at the ends.

Other variants can be seen in the rest of the specification.

### DESCRIPTION OF FIGURES

For a better understanding of the invention, the following figures are included, which show exemplary embodiments.
Figure 1: Perspective view of an example of a heat sink (A) assembled, (B) partially exploded.
Figure 2: Longitudinal section of a second example, showing the internal triangular shape.
Figure 3: Two examples of inserts (A) straight, (B) convex.
Figure 4: Two examples of fins, with secondary fins (A) and with mass fins only (B).
Figure 5: Example of top of housing with fin insertion slots.
Figure 6: Temperature curve versus time elapsed in two tests (25 and 50W), each with and without insert.
Figure 7: Temperature curve according to the elapsed time in two tests, with 25W (7A) and with 50W (7B), without inlet hole, with hole but without triangular shape and with hole and triangular shape.

### MODES OF CARRYING OUT THE INVENTION

Next, a brief description is given of one embodiment of the invention, as an illustrative and non-limiting example thereof.

The heat sink of the embodiment shown in the figures comprises a casing (1) with a long flat major face (11), two major faces and two bases (12) approximately perpendicular to the flat major face (11). As can be seen, the shape represented is rectangular prismatic. The casing (1) is hollow and has three holes (2,3) that communicate its interior with the exterior. An inlet hole (2) facing a midpoint of the flat major face (11), on the other side of the casing (1) and two outlet holes (3) in the bases (12). The area of the inlet hole (2) is approximately equal to the sum of the areas of the outlet holes (3).

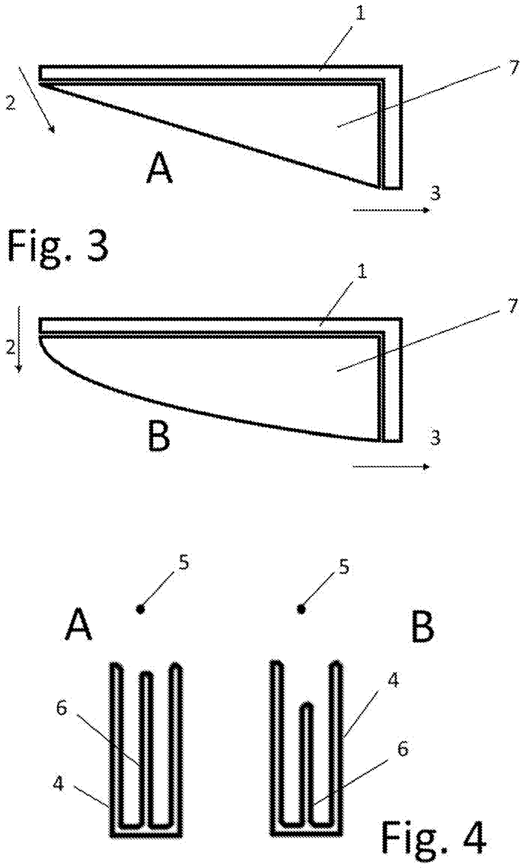

On the flat major face (11) there is a series of ground fins (4) close to a conductive wire (5) that acts as a corona electrode. The ground fins (4) are parallel to the conductive wire (5), and occupy all or most (at least 80%) of the length of the flat major face (11). That is, they go from one base (3) to the other base (3). The conductive wire (5) is connected to a high voltage electricity source that allows it to be charged with an electrostatic charge. The ground fins (4) are charged with a charge in the opposite direction. It is possible to place secondary fins (6) between the ground fins (4) that do not act with the conductive wire (5) (figure 4A). To do this, they can be shorter than the ground fins (4) or have an insulating coating. These secondary fins (6) increase the heat exchange surface.

As can be seen, the ground fins (4) have a height similar to the height of the outlet holes (3), so that the fluid passing through them has been in contact with some fins (4,6).

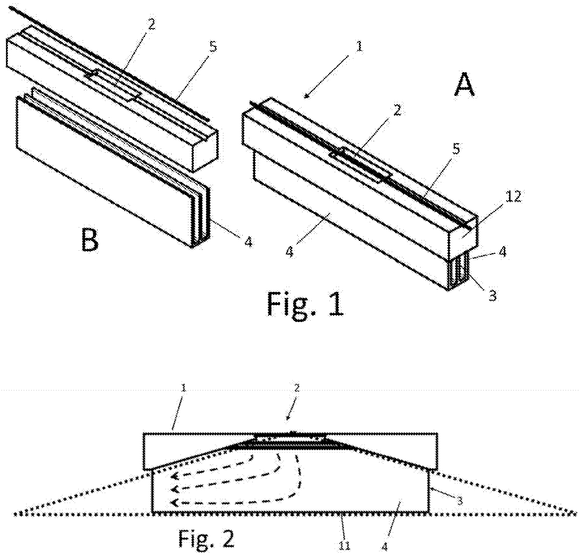

The interior of the casing (1) has a substantially triangular shape, with a greater height corresponding to the distance between the larger flat face (11) and the inlet hole (2) and a width corresponding to the distance between the bases (12), i.e. the length of the larger flat face (11). Figure 2 shows that two vertices are truncated by the presence of the outlet holes (3) and the third by the inlet hole (2). This interior of the casing (1) may have the sides between the inlet hole (2) and the two outlet holes (3) straight or concave.

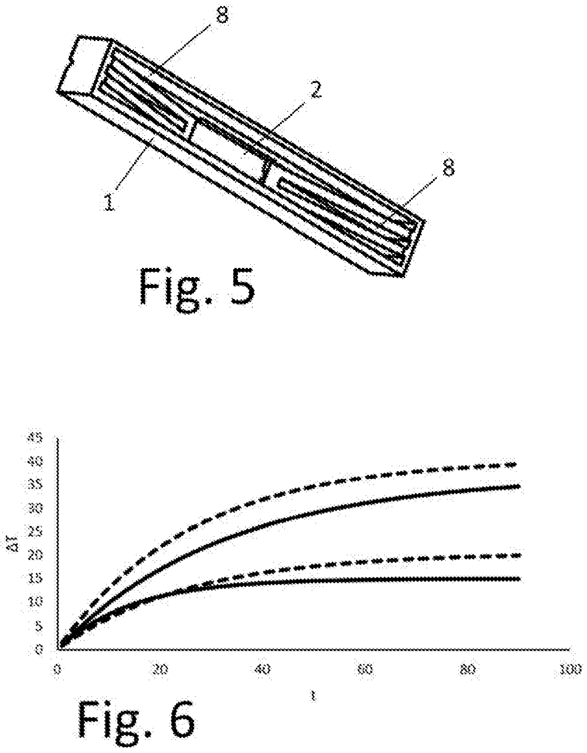

The way to achieve this triangular shape inside the casing (1) can be done directly by the shape of the casing (1), which in this case is also triangular, or by using inserts (7) that define the shape of the inside of the casing (1). These inserts (7) modify the shape of the casing (1), which has been represented as rectangular prismatic, so that its interior has the desired shape. Thus, in figure 2 the inserts (7) generate chamfers. Figure 5 shows an embodiment in which the upper part of the casing (1) has internal slots (8) through which the ground fins (4) are inserted. This reduces the effective section at the ends, near the outlet holes (3), accelerating the passage of the fluid.

It can be seen, especially in figure 1, that the conductive wire (5) is external to the casing (1), insulating, so that it is only directly facing the ground fins (4) in the entry hole. A notch in the surface of the casing (1) carries the conductive wire (5) to bring it closer to the ground fins (4) and ensure that it does not protrude from the surface of the device. The conductive wire (5) is anchored to the casing (1) to avoid accidental movements that modify the relative positions.

Figure 3 shows various ways of making the inserts (7). They can have flat walls (Figure 3A) or modify their curvature depending on the distance to the inlet hole (2). For example, in Figure 3B the slope of the insert (7) in the area close to the inlet hole (2) is perpendicular to it, while it reaches the corresponding outlet hole (3) also perpendicular to it. Thus, the shape represented is a sector of an ellipse. Other curvatures are possible (oval, ovoid, sinusoidal, hyperbole sectors...).

Thanks to the more or less triangular shape of the inside of the casing (1), the fluid passing through the inlet hole (2) is directed directly to the fins (4,6) to carry out the heat exchange, without producing turbulence that reduces the effectiveness, by reducing the contact time and increasing the loss of charge. However, as can be seen in figure 2, there is relatively cold fluid that reaches the end of the fins (4,6), so the temperature differential is maximum and that area is also cooled.

The direction of fluid circulation is ensured by the discharge itself and the channels formed between the insulating structure and the ground electrode or ground fins (4). The discharge is carried out on the tips of the ground fins (4) and the ionic wind is pushed towards the interior of the device, the channels formed between the structure and ground fins (4) are the reason why the flow is directed in that direction.

Thus, Figure 6 shows the evolution over time of the temperature difference between the plate to be cooled and the environment in four tests. The dashed lines use a casing (1) with a rectangular prismatic interior, without an insert (7). The solid lines show the case with a straight-line insert (7) that makes the interior triangular. The upper curves correspond to a 50W heat source and the lower ones to a 25W heat source. It can be seen how the modification of the shape of the inside of the casing allows an increase in efficiency of up to 24% (25W case).

The tests were carried out with an 80x80 mm aluminium plate heated by a resistor covering an area of 50x50 mm, and with a power of 25 and 50 W. The device coupled to the plate comprised eleven pairs of electrodes, covering 80x80 mm, either of rectangular (control) or right triangular inner area. The ground fins (4) had a height of 19 mm and the central fins also act as ground fins (4), with a height of 18.1 mm, the width of all being 1 mm. The distance between extreme ground fins (4) is 6 mm and the central fins were centred in that space. The channels had a length of 80 mm. The length of the inlet hole (2) is 20 mm. The height of the outlet holes (3) is 10 mm, the total area of the outlet holes (3) being equal to the area of the inlet hole (2). The ground electrode is made of aluminium, by additive manufacturing, and the power of the device is 5W.

The temperature measurement was carried out by thermocouples inserted in the aluminium plate, comparing it with the ambient temperature.

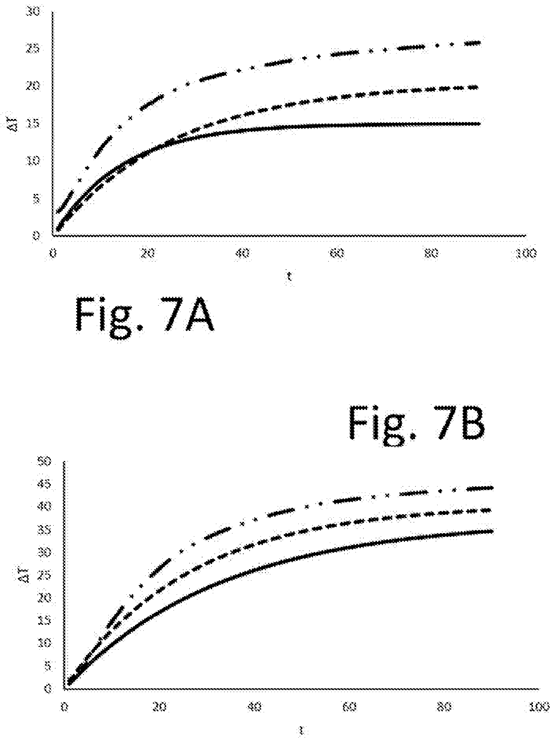

It is also interesting to see the test shown in figure 7, where a model like the one claimed, with a 20 mm inlet hole, is compared (continuous line), a model with a 20 mm inlet hole, without the triangular shape (dashed line) and a model where most of the upper surface of the casing (1) is open, leaving the conductive wire (5) accessible for almost the entire length of the ground fin (4), that is, 75 mm of the 80 mm of the ground fin (4), (dotted and dashed line). This last model corresponds to the one shown in the Korean patent KR101513402. These tests have been carried out by using heat sinks like those described in the previous example to evacuate the heat from an 80x80 mm metal plate using a 50x50 mm thermal resistor and supplying 25W (figure 7A) or 50W (figure 7B). The evolution of the temperature over time is shown in these two cases. The temperature of the plate is monitored temporarily through thermocouples. The power of the device in all examples is approximately 5W. It can be seen that the solution of the Korean patent is the one that produces the least dissipation.

Figure 1 shows how the casing (1) has two parts that fit together. A first part comprising the inserts (7) and the inlet hole (2) and a second part which is formed by the flat larger face (11) and the fins (4,6).

The device can be modular, applying several sets of fins (4,6), casings (1), conducting wires (5). in parallel, so that the element whose heat is to be dissipated can be cooled according to its needs. In this case, the first part stated in the previous paragraph can be common to several modules.

## Claims

1. Electrohydrodynamic heat sink, formed by an elongated casing (1) having a flat larger face (11) carrying ground fins (4), wherein the casing (1) has:
an inlet hole (2) at a central point facing the ground fins (4),
a conductive wire (5), close to, and parallel to, the ground fins (4), which passes through the inlet hole (2), and
two outlet holes (3) of the casing at the ends of the ground fins (4),
**characterized in that** the inner hollow of the casing (1) has a substantially truncated triangular shape, with a height corresponding to the distance between the flat larger face (11) and the inlet hole (2) and a base corresponding to the flat larger face (11) between the outlet holes (3).

2. Electrohydrodynamic heat sink, according to claim 1, **characterized in that** the area of the inlet hole (2) is similar to the total area of the outlet holes (3).

3. Electrohydrodynamic heat sink, according to claim 1, **characterized in that** it comprises secondary fins (6), parallel to the ground fins (4), and electrostatically independent of the conductive wire (5).

4. Electrohydrodynamic heat sink, according to claim 1, **characterized in that** the ground fins (4) have a height similar to the height of the outlet holes (3).

5. Electrohydrodynamic heat sink, according to claim 1, **characterized in that** the casing (1) comprises inserts (7) that define the triangular shape.

6. Electrohydrodynamic heat sink, according to claim 5, **characterized in that** the inserts (7) have a straight wall oriented towards the hollow of the housing (1).

7. Electrohydrodynamic heat sink, according to claim 5, **characterized in that** the inserts (7) have a convex wall oriented towards the hollow of the housing (1).

8. Electrohydrodynamic heat sink, according to claim 1, **characterized in that** the conductive wire (5) is outside the casing (1), such that the latter is insulating and is arranged between the ground fins (4) and the conductive wire (5) except in the inlet hole (2).

9. Electrohydrodynamic heat sink, according to claim 1, **characterized in that** the inner part of the casing (1) has internal slots (8) for inserting the ends of the ground fins (4).
